# FASCICULE DE BREVET EUROPEEN

(11) **EP 2 786 491 B1**
(45) Date de publication et mention de la délivrance du brevet: **02.09.2020**
(21) Numéro de dépôt: 12801505.4
(22) Date de dépôt: 30.11.2012
(51) Int. Cl.: H03K 17/955

(54) **CAPTEUR DE DECLENCHEMENT D'UNE ACTION SUR UN OUVRANT DE VEHICULE AUTOMOBILE**
SENSOR ZUR AUSLÖSUNG EINER AKTION EINER TÜR EINES KRAFTFAHRZEUGS
SENSOR FOR TRIGGERING AN ACTION ON A DOOR OF A MOTOR VEHICLE

(30) Priorité: 02.12.2011 FR 1103687
(43) Date de publication de la demande: 08.10.2014
(73) Titulaire: Valeo Comfort and Driving Assistance, 94046 Créteil Cedex (FR)
(72) Inventeur: MENARD, Eric, F-94046 Créteil Cedex (FR); MUSAT, Ciprian, F-94046 Créteil Cedex (FR)
(74) Mandataire: Pothmann, Karsten
(86) Numéro de dépôt international: PCT/EP2012/074050
(87) Numéro de publication internationale: WO 2013/079642

(56) Documents cités:
- EP-A1- 1 584 777
- WO-A1-2005/116376
- DE-A1-102005 055 515
- DE-A1-102010 019 362
- DE-A1-102010 019 362
- US-A1- 2005 068 712
- Gabriel Sanchez ET AL: "Convert your 8-bit MCU into a smart Touch Sensor", Microcontroller Solutions Group, 1 November 2009 (2009-11-01), pages 1-60, XP055620847, US Retrieved from the Internet: URL:https://www.nxp.com/files-static/train ing_pdf/WBNR_8BIT_TOUCHSENSING.pdf [retrieved on 2019-09-11]

## Description

La présente invention concerne un capteur de déclenchement d'une action sur un ouvrant de véhicule automobile. Elle s'applique notamment au domaine du verrouillage et déverrouillage de l'ouvrant d'une porte de véhicule. L'invention trouve une application particulièrement intéressante dans le domaine automobile.

Il est connu d'utiliser un capteur capacitif de déclenchement du verrouillage et déverrouillage d'une porte de véhicule automobile. Comme le corps humain est constitué de deux tiers d'eau, l'approche du doigt ou de la main de l'utilisateur vers l'électrode du capteur capacitif fait varier sa capacité. Le capteur capacitif comporte également une unité de gestion qui déclenche le verrouillage ou le déverrouillage de la porte en fonction de l'information délivrée par l'électrode, c'est-à-dire en fonction de la variation de capacité de cette dernière.

Un inconvénient est qu'un tel capteur capacitif comporte une électrode sensible à la valeur de la capacité de l'environnement. Ainsi, lorsqu'une pièce décorative conductrice est positionnée à proximité de l'électrode, par exemple sur la face externe d'un levier de préhension, la sensibilité de l'électrode est diminuée par cette pièce décorative conductrice.

De même, lors d'une averse de pluie, un filet d'eau peut ruisseler entre la pièce décorative conductrice et l'électrode. Dans ce cas de figure, la capacité de l'électrode varie et cette variation est interprétée à tort par l'unité de gestion comme une action de l'utilisateur de verrouillage ou de déverrouillage de l'ouvrant.

L'état de la technique est illustré par les documents DE 10 2010 019362 A1, et "Convert your 8-bit MCU into a smart Touch Sensor", par Gabriel Sanchez et al., Microcontroller Solutions Group, pages 1-60,1 novembre 2009, https://www.nxp.com/files-static/training_pdf/WBNR_8BIT_TOUCHSENSING.pdf.

Le dispositif de l'invention a donc plus particulièrement pour but de remédier aux inconvénients de l'état de la technique précité. Dans ce contexte, l'invention vise à proposer un capteur de déclenchement d'une action sur un ouvrant de véhicule automobile apte à être positionné à proximité d'un élément conducteur et à réaliser une action de verrouillage ou de déverrouillage d'un ouvrant de véhicule correspondant à un véritable souhait d'un utilisateur.

A cette fin, l'invention porte sur un capteur de déclenchement d'une action sur un ouvrant de véhicule automobile selon la revendication 1.

Le capteur de déclenchement selon l'invention permet, grâce aux signatures des variations de capacité de chacune des deux électrodes, de s'assurer que les variations de capacité sont dues à l'approche d'une main et non à l'environnement extérieur comme par exemple la pluie.

On entend pour la suite de la description par décalée dans l'espace, le fait que la première zone et la deuxième zone ne se recouvre pas entièrement. En d'autres termes, la première zone et la deuxième zone se recouvrent seulement en partie voire pas du tout. En outre, l'orientation de la première zone peut différer de l'orientation de la deuxième zone.

Dans un mode de réalisation non limitatif, la deuxième électrode est une bi-électrode de sorte que la surface de la deuxième zone soit augmentée.

Chaque électrode est connectée à l'unité de traitement au moyen :
- d'une unique connexion connectée à l'unité de traitement, ladite unique connexion formant de façon alternative l'entrée de mesure ou la sortie de commande.

La sortie de commande ou l'unique connexion de l'unité de traitement est adaptée pour :
- positionner le potentiel de la première électrode au même niveau que celui de la deuxième électrode, ou
- positionner le potentiel de la deuxième électrode au même niveau que celui de la première électrode.

Dans un mode de réalisation non limitatif, le positionnement du potentiel est assuré de façon périodique et alternative entre la première électrode et la deuxième électrode.

Dans un mode de réalisation non limitatif, le capteur de déclenchement comporte un plan dit de garde.

Dans un mode de réalisation non limitatif, la deuxième électrode est adaptée pour être positionnée en regard d'un élément conducteur.

L'invention a également pour objet levier de préhension comportant un capteur de déclenchement selon l'invention.

L'invention porte en outre sur un procédé de déclenchement d'une action sur un ouvrant de véhicule automobile mettant en œuvre le capteur de déclenchement selon l'une des revendications précédentes, ledit procédé comportant les étapes selon la revendication 6.

D'autres caractéristiques et avantages de l'invention ressortiront clairement de la description qui en est donnée ci-après, à titre indicatif et nullement limitatif, en référence aux figures annexées ci-jointes, parmi lesquelles :
- la figure 1 illustre un exemple non revendiqué d'un capteur de déclenchement d'une action sur un ouvrant de véhicule automobile ;
- la figure 2 illustre un premier mode de réalisation non limitatif d'un capteur de déclenchement d'une action sur un ouvrant de véhicule automobile conforme à l'invention ;
- la figure 3 illustre un deuxième mode de réalisation non limitatif d'un capteur de déclenchement d'une action sur un ouvrant de véhicule automobile conforme à l'invention ;
- la figure 4 illustre un exemple non revendiqué d'un capteur de déclenchement d'une action sur un ouvrant de véhicule automobile ;
- la figure 5 illustre un troisième mode de réalisation non limitatif d'un capteur de déclenchement d'une action sur un ouvrant de véhicule automobile conforme à l'invention ;
- la figure 6 représente une coupe d'un ouvrant comportant un levier de préhension conforme à l'invention ;
- les figures 7A à 7E représentent des signatures de variations de capacité des électrodes d'un capteur de déclenchement conforme à l'invention ;
- la figure 8 représente une coupe d'un ouvrant comportant un levier de préhension conforme à l'invention ;
- la figure 9 illustre un procédé de déclenchement d'une action sur un ouvrant de véhicule automobile conforme à l'invention.

Pour des raisons de clarté, seuls les éléments essentiels pour la compréhension de l'invention ont été représentés, et ceci sans respect de l'échelle et de manière schématique.

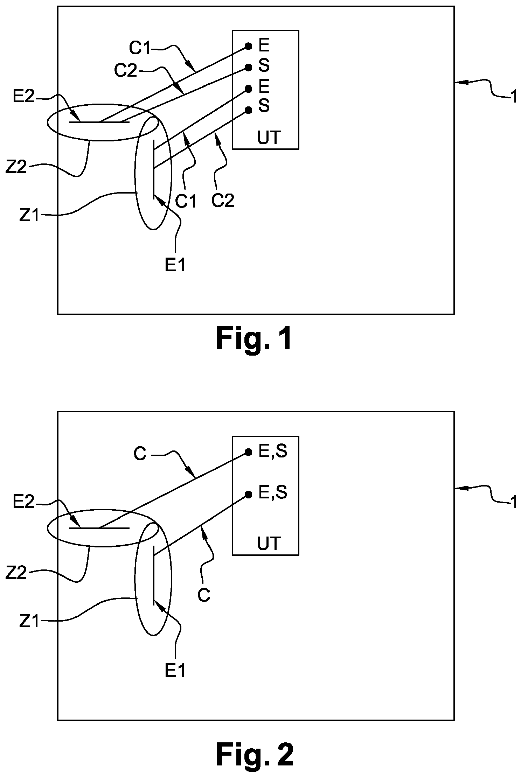

La figure 1 représente un exemple non revendiqué d'un capteur de déclenchement 1 d'une action sur un ouvrant de véhicule automobile.

Le capteur de déclenchement 1 comporte :
- une première électrode E1 de mesure de capacité définissant une première zone de détection Z1 et une deuxième électrode E2 de mesure de capacité définissant une deuxième zone de détection Z2, la première électrode E1 et la deuxième électrode E2 étant agencées de sorte que la première zone Z1 et la deuxième zone Z2 soient décalées dans l'espace,
- une unité de traitement UT connectée à la première électrode E1 et à la deuxième électrode E2 pour détecter des variations de capacité des deux électrodes E1, E2 et pour générer une action de déclenchement sur l'ouvrant du véhicule automobile en fonction des signatures des variations de capacité de chacune des deux électrodes E1, E2 dues à l'approche d'une main des deux zones de détection Z1, Z2.

En d'autres termes, lorsqu'une main s'approche des zones de détection Z1 et Z2, elle fait varier la capacité des électrodes E1, E2. L'association des signatures des variations de capacité des deux électrodes E1 et E2 permet de différencier des variations de capacité dues à l'approche d'une main, des variations de capacité dues à l'environnement extérieur comme par exemple la pluie.

Dans le capteur de déclenchement 1 représenté sur la figure 1, la première électrode E1 est connectée à l'unité de traitement UT au moyen d'une première connexion C1 connectée à une entrée E de mesure de l'unité de traitement UT, l'entrée de mesure E étant adaptée pour mesurer la variation de capacité de la première électrode E1. La première électrode E1 est également connectée à l'unité de traitement UT au moyen d'une deuxième connexion C2 connectée à une sortie S de commande, la sortie de commande S étant adaptée pour commander le potentiel de la première électrode E1. De surcroît, la deuxième électrode E2 est connectée à l'unité de traitement UT au moyen d'une première connexion C1 connectée à une entrée E de mesure de l'unité de traitement UT, l'entrée de mesure E étant adaptée pour mesurer la variation de capacité de la deuxième électrode E2. La deuxième électrode E2 est également connectée à l'unité de traitement UT au moyen d'une deuxième connexion C2 connectée à une sortie S de commande, la sortie de commande S étant adaptée pour commander le potentiel de la deuxième électrode E2.

Les sorties de commande S de l'unité de traitement UT sont adaptées pour :
- positionner le potentiel de la première électrode E1 au même niveau que celui de la deuxième électrode E2, ou
- positionner le potentiel de la deuxième électrode E2 au même niveau que celui de la première électrode E1.

Il convient de noter que le positionnement du potentiel est assuré de façon périodique et alternative entre la première électrode E1 et la deuxième électrode E2. La période est par exemple comprise entre 2 et 20 ms.

En d'autres termes, la première électrode E1 et la deuxième électrode E2 assurent alternativement une fonction dite de garde. Cette fonction de garde permet de minimiser le couplage capacitif entre les électrodes E1 et E2. Ainsi, chaque électrode E1, E2 délivre sa propre information sans être perturbée (diaphonie) par l'électrode voisine améliorant ainsi la performance du traitement de signal associé.

La figure 2 illustre un premier mode de réalisation d'un capteur de déclenchement 1 conforme à l'invention.

Dans ce premier mode de réalisation non limitatif, chaque électrode E1, E2 est connectée à l'unité de traitement UT au moyen d'une unique connexion C connectée à l'unité de traitement UT. Chaque unique connexion C forme de façon alternative l'entrée E de mesure adaptée pour mesurer la variation de capacité de l'électrode correspondante ou la sortie S de commande adaptée pour commander le potentiel de l'électrode correspondante.

Ainsi, les uniques connexions C de l'unité de traitement UT sont adaptées pour :
- positionner le potentiel de la première électrode E1 au même niveau que celui de la deuxième électrode E2, ou
- positionner le potentiel de la deuxième électrode E2 au même niveau que celui de la première électrode E1.

En outre, le positionnement du potentiel est assuré de façon périodique et alternative entre la première électrode E1 et la deuxième électrode E2.

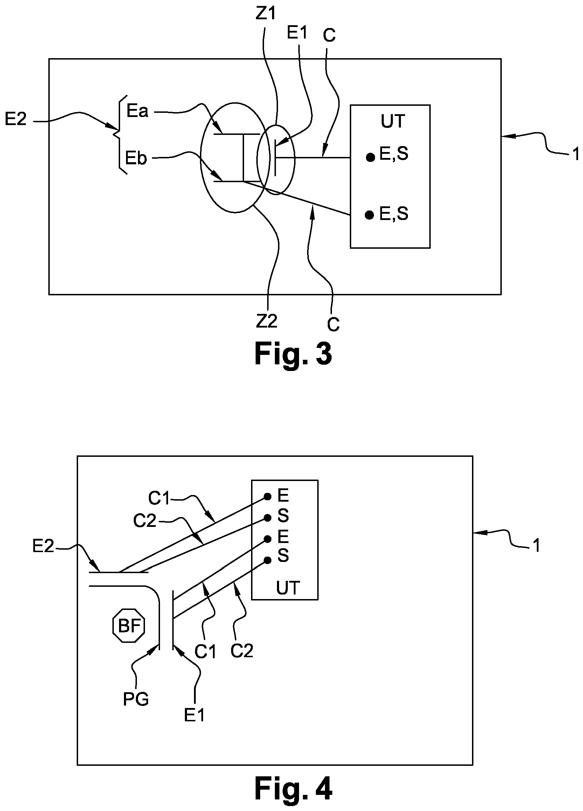

La figure 3 représente un deuxième mode de réalisation du capteur de déclenchement 1 selon l'invention.

Dans cette réalisation, la deuxième électrode E2 est une bi-électrode de sorte que la surface de la deuxième zone Z2 soit augmentée. Cette bi-électrode comporte deux électrodes E2a et E2b. Les électrodes E2a et E2b sont reliées électriquement entre elles de sorte que la variation de la capacité d'au moins une des deux électrodes E2a et E2b soit détectée via l'entrée E de mesure correspondante.

La figure 4 représente un exemple non revendiqué d'un capteur de déclenchement 1.

De façon comparative au capteur de déclenchement illustré sur la figure 1, le capteur de déclenchement 1 comporte un plan dit de garde PG également connu sous les termes « anneau de garde ». Le plan de garde PG permet de diminuer les phénomènes parasites. De tels phénomènes parasites peuvent être dus à une antenne basse fréquence BF positionnée à proximité des électrodes E1 et E2. Une telle antenne BF peut être nécessaire afin d'assurer la communication entre le capteur et une carte électronique adaptée pour déclencher le verrouillage ou le déverrouillage de l'ouvrant d'un véhicule.

Il est entendu que le capteur capacitif 1 peut comporter un plan de garde et en outre être adapté pour positionner le potentiel de la première électrode E1 au même niveau que celui de la deuxième électrode E2, ou positionner le potentiel de la deuxième électrode E2 au même niveau que celui de la première électrode E1, le positionnement du potentiel étant assuré de façon périodique et alternative entre la première électrode E1 et la deuxième électrode E2.

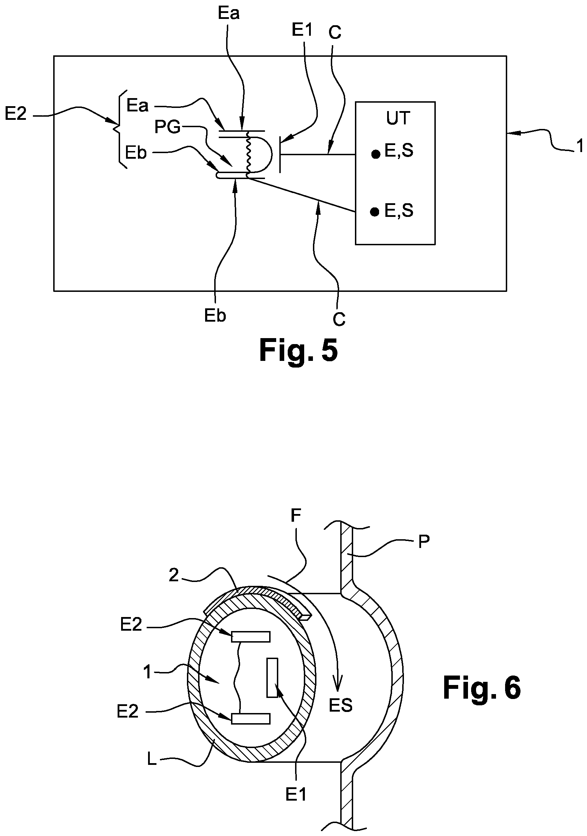

La figure 5 représente un troisième mode de réalisation d'un capteur de déclenchement 1 conforme à l'invention.

De façon comparative au capteur de déclenchement 1 illustré sur la figure 3, le capteur de déclenchement 1 comporte un plan dit de garde PG.

Dans une réalisation non limitative, l'unité de traitement UT est formée par un microcontrôleur muni de moyens de mesure de la capacité électrique des électrodes. Avantageusement, le paramétrage d'un microcontrôleur peut être modifié de façon simple.

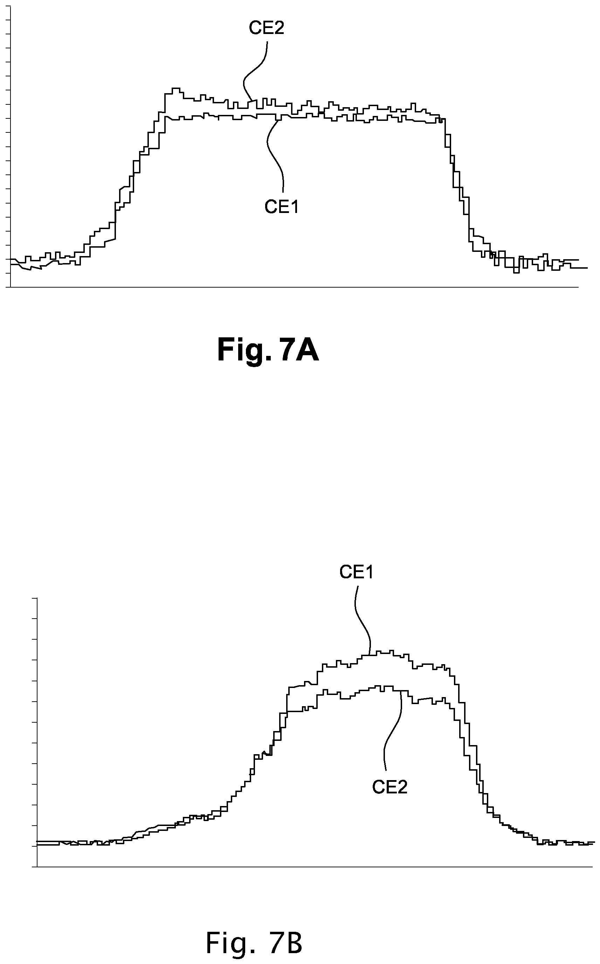

La figure 6 illustre une vue en coupe d'un ouvrant P, par exemple une porte, de véhicule automobile sur lequel est monté un levier de préhension L conforme à l'invention. Le levier de préhension L (ou poignée) intègre un capteur de déclenchement 1. Pour ouvrir l'ouvrant P, l'utilisateur doit passer sa main entre le levier de préhension L et l'ouvrant P suivant le sens de la flèche F. La main est donc positionnée dans l'espace ES. Dans cette mise en œuvre particulière non limitative du levier de préhension L, le levier L comporte un élément conducteur 2 positionné en regard de la deuxième électrode E2. L'élément conducteur 2 est par exemple un élément chromé décoratif. Dans ce cas, l'élément conducteur décoratif est par exemple électriquement flottant, c'est-à-dire qu'il n'est pas relié à la masse du véhicule, ceci permet de réduire les coûts de fabrication.
Pour mémoire, l'unité de traitement UT (non représentée sur cette figure) du capteur de déclenchement 1 est connectée à la première électrode E1 et à la deuxième électrode E2 pour détecter des variations de capacité des deux électrodes E1, E2 et pour générer une action de déclenchement sur l'ouvrant du véhicule automobile en fonction des signatures des variations de capacité de chacune des deux électrodes E1, E2 dues à l'approche d'une main des deux zones de détection Z1, Z2. Les figures 7A à 7E représentent des graphiques illustrant des exemples non limitatifs de signatures. Le temps est représenté sur l'axe des abscisses et la capacité est représentée sur l'axe des ordonnées en femto farad. La signature de la variation de capacité de la première électrode E1 est représentée par la courbe CE1 et la signature de la variation de capacité de la deuxième électrode E2 est représentée par la courbe CE2.

Dans l'exemple illustré sur la figure 7A, on peut noter que la capacité de la première électrode E1 est quasiment identique à la capacité de la deuxième électrode E2 et que les périodes de variation de capacité de ces deux électrodes E1, E2 sont également quasiment identiques. En outre, la capacité de la deuxième électrode E2 est légèrement supérieure à la capacité de la première électrode E1. De telles signatures illustrent le fait que la main de l'utilisateur est à proximité des deux électrodes E1 et E2, c'est-à-dire dans l'espace ES, mais pas encore au contact du levier de préhension L. En d'autres termes, la main de l'utilisateur entoure le levier de préhension L sans être à son contact.

Dans l'exemple illustré sur la figure 7B, on peut noter une légère différence entre la capacité de la première électrode E1 et la capacité de la deuxième électrode E2, la capacité de la première électrode E1 étant supérieure à la capacité de la deuxième électrode E2 sur la période de variation. En outre, les périodes de variation de capacité de ces deux électrodes E1, E2 sont quasiment identique. De telles signatures illustrent le fait que la main de l'utilisateur est au contact du levier de préhension L et dans l'espace ES. En d'autres termes, l'utilisateur est prêt à ouvrir la porte du véhicule.

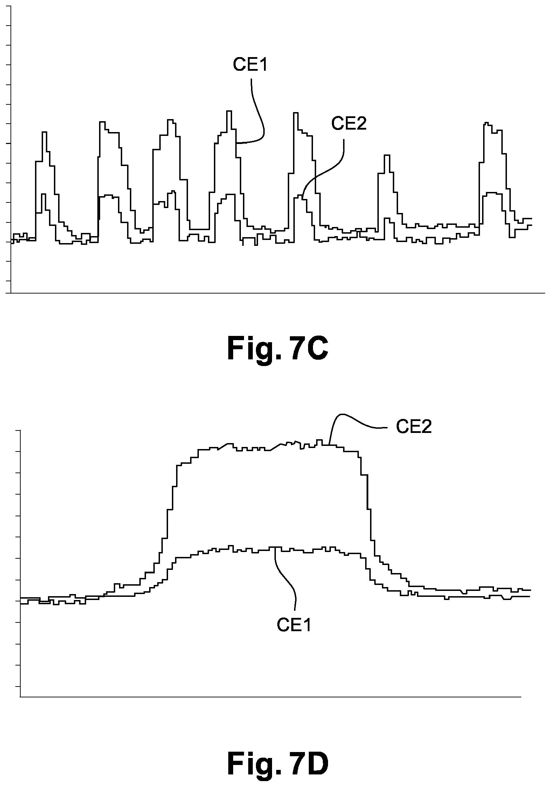

Dans l'exemple illustré sur la figure 7C, on peut noter que la capacité de la première électrode E1 varie fortement sur de courtes périodes tandis que la capacité de la deuxième électrode E2 varie faiblement su des périodes identiques. Ces signatures sont typiques d'un ruissellement d'eau s'écoulant le long de la carrosserie de la porte P.

Dans l'exemple illustré sur la figure 7D, on peut noter que pour une période quasiment identique la capacité de la première électrode E1 varie très peu tandis que la capacité de la deuxième électrode E2 varie fortement. Ces deux signatures sont typiques d'une main située devant le levier de préhension L.

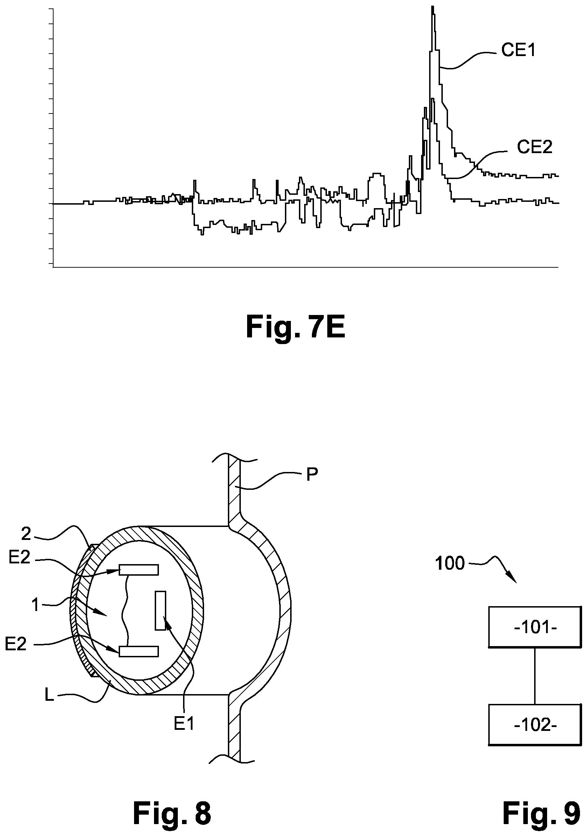

Dans l'exemple illustré sur la figure 7E, les capacités des deux électrodes E1 et E2 sont décorrélées. De telles signatures sont significatives d'une averse de pluie.

De manière générale, dans le cas où les deux signatures de variation de capacité sont typiques d'une approche de main, alors une action de verrouillage ou de déverrouillage est réalisée sur l'ouvrant du véhicule. A l'inverse, dans le cas où les deux signatures de variation de capacité sont typiques de la pluie, alors aucune action de verrouillage ni même de déverrouillage n'est réalisée. En d'autres termes, les signatures permettent de filtrer les phénomènes non désirés comme le déverrouillage d'une porte de manière intempestive lorsque l'utilisateur est situé à proximité du capteur de déclenchement 1 que comporte un véhicule mais qu'il n'a pas approché sa main du capteur de déclenchement 1 et qu'il pleut.

Dans une mise en œuvre différente illustrée sur la figure 8, l'élément conducteur 2 n'est pas positionné en regard de la deuxième électrode E2, mais est positionné sur la face externe du levier de préhension L et en regard de la première électrode E1.

L'invention a également pour objet un procédé de déclenchement 100 d'une action sur un ouvrant de véhicule automobile mettant en œuvre le capteur de déclenchement 1 selon l'invention (figure 9). Le procédé 100 comporte les étapes de:
- détecter 101 des variations de capacité des électrodes E1, E2, la détection 101 étant réalisée par l'unité de traitement UT du capteur capacitif C,
- déclencher 102 une action sur un ouvrant de véhicule automobile par l'unité de traitement 2, le déclenchement 102 étant réalisé si les signatures des variations de capacité de chacune des deux électrodes E1, E2 sont représentatives de l'approche d'une main des deux zones de détection Z1, Z2.

Les signatures permettent de différencier des variations de capacité dues à l'approche d'une main de celles dues à l'environnement extérieur comme la pluie. Ainsi, une action de verrouillage ou de déverrouillage est réalisée uniquement si un utilisateur le souhaite.

L'invention est décrite dans ce qui précède à titre d'exemple et il est entendu que les signatures présentées à l'appui de la figure 7 ne sont pas limitatives et d'autres types de signatures peuvent être utilisés sans pour autant sortir du cadre de l'invention, qui est défini par les revendications suivantes.

## Revendications

1. Capteur de déclenchement (1) d'une action sur un ouvrant (P) de véhicule automobile comportant :
- une première électrode (E1) de mesure de capacité définissant une première zone de détection (Z1) et une deuxième électrode (E2) de mesure de capacité définissant une deuxième zone de détection (Z2), ladite première électrode (E1) et ladite deuxième électrode (E2) étant agencées de sorte que ladite première zone (Z1) et ladite deuxième zone (Z2) soient décalés dans l'espace,
- une unité de traitement (UT) connectée à ladite première électrode (E1) et à ladite deuxième électrode (E2) pour détecter des variations de capacité des deux électrodes (E1, E2) et pour générer une action de déclenchement sur l'ouvrant (P) du véhicule automobile en fonction des signatures (CE1, CE2) des variations de capacité de chacune des deux électrodes (E1, E2) dues à l'approche d'une main des deux zones de détection (Z1, Z2),
**caractérisé en ce que** chaque électrode (E1, E2) est connectée à l'unité de traitement (UT) au moyen d'une unique connexion (C) connectée à l'unité de traitement (UT), ladite unique connexion (C) formant de façon alternative une entrée de mesure (E) adaptée pour mesurer la variation de capacité de l'électrode ou une sortie de commande (S) adaptée pour commander le
potentiel de l'électrode correspondante, les uniques connexions de l'unité de traitement (UT) associées au deux électrodes (E1, E2) étant en outre adaptées pour :
- positionner le potentiel de la première électrode E1 au même niveau que celui de la deuxième électrode E2, ou
- positionner le potentiel de la deuxième électrode E2 au même niveau que celui de la première électrode E1,
un positionnement du potentiel étant assuré de façon périodique et alternative entre la première électrode (E1) et la deuxième électrode (E2).

2. Capteur de déclenchement (1) selon la revendication précédente dans lequel la deuxième électrode (E2) est une bi-électrode de sorte que la surface de la deuxième zone (Z2) soit augmentée.

3. Capteur de déclenchement (1) selon l'une des revendications précédentes comportant un plan dit de garde (PG).

4. Capteur de déclenchement (1) selon l'une des revendications précédentes selon lequel la deuxième électrode (E2) est adaptée pour être positionnée en regard d'un élément conducteur (2).

5. Levier de préhension (L) **caractérisé en ce qu'**il comporte un capteur de déclenchement (1) selon l'une des revendications précédentes.

6. Procédé de déclenchement (100) d'une action sur un ouvrant de véhicule automobile mettant en œuvre le capteur de déclenchement (1) selon l'une des revendications précédentes, ledit procédé (100) comportant les étapes de:
- détecter (101) des variations de capacité des électrodes (E1, E2), ladite détection (101) étant réalisée par l'unité de traitement (UT) du capteur capacitif (C),
- déclencher (102) une action sur un ouvrant (P) de véhicule automobile par l'unité de traitement (2), ledit déclenchement (102) étant réalisé si les signatures (CE1, CE2) des variations de capacité de chacune des deux électrodes (E1, E2) sont représentatives de l'approche d'une main des deux zones de détection (Z1, Z2).

## Patentansprüche

1. Sensor zur Auslösung (1) einer Aktion einer Tür (P) eines Kraftfahrzeugs, umfassend:
- eine erste Elektrode (E1) zur Kapazitätsmessung, die eine erste Erfassungszone (Z1) definiert, und eine zweite Elektrode (E2) zur Kapazitätsmessung, die eine zweite Erfassungszone (Z2) definiert, wobei die erste Elektrode (E1) und die zweite Elektrode (E2) derart angeordnet sind, dass die erste Zone (Z1) und die zweite Zone (Z2) räumlich versetzt sind,
- eine Verarbeitungseinheit (UT), die an die erste Elektrode (E1) und an die zweite Elektrode (E2) angeschlossen ist, um Kapazitätsveränderungen der zwei Elektroden (E1, E2) zu erfassen, und um eine Aktion zur Auslösung der Tür (P) des Kraftfahrzeugs in Abhängigkeit von den Signaturen (CE1, CE2) der Kapazitätsveränderungen jeder der zwei Elektroden (E1, E2) aufgrund der Annäherung einer Hand an die zwei Erfassungszonen (Z1, Z2) zu erzeugen,
**dadurch gekennzeichnet, dass** jede Elektrode (E1, E2) an die Verarbeitungseinheit (UT) mit Hilfe eines einzigen Anschlusses (C) angeschlossen ist, der an die Verarbeitungseinheit (UT) angeschlossen ist, wobei der einzige Anschluss (C) alternativ einen Messeingang (E), der dazu vorgesehen ist, die Kapazitätsveränderung der Elektrode zu messen, oder einen Steuerausgang (S) bildet, der dazu vorgesehen ist, das Potential der entsprechenden Elektrode zu steuern, wobei die einzigen Anschlüsse der Verarbeitungseinheit (UT), die den zwei Elektroden (E1, E2) zugeordnet sind, ferner dazu vorgesehen sind:
- das Potential der ersten Elektrode (E1) auf demselben Niveau wie jenes der zweiten Elektrode (E2) zu positionieren, oder
- das Potential der zweiten Elektrode (E2) auf demselben Niveau wie jenes der ersten Elektrode (E1) zu positionieren,
wobei eine Positionierung des Potentials periodisch und alternativ zwischen der ersten Elektrode (E1) und der zweiten Elektrode (E2) gewährleistet wird.

2. Auslösungssensor (1) nach dem vorhergehenden Anspruch, bei dem die zweite Elektrode (E2) eine Bi-Elektrode ist, so dass die Fläche der zweiten Zone (Z2) vergrößert ist.

3. Auslösungssensor (1) nach einem der vorhergehenden Ansprüche, umfassend eine so genannte Schutzebene (PG).

4. Auslösungssensor (1) nach einem der vorhergehenden Ansprüche, bei dem die zweite Elektrode (E2) dazu vorgesehen ist, gegenüber einem leitenden Element (2) positioniert zu sein.

5. Greifhebel (L), **dadurch gekennzeichnet, dass** er einen Auslösungssensor (1) nach einem der vorhergehenden Ansprüche umfasst.

6. Verfahren zur Auslösung (100) einer Aktion einer Tür eines Kraftfahrzeugs, das den Auslösungssensor (1) nach einem der vorhergehenden Ansprüche einsetzt, wobei das Verfahren (100) die folgenden Schritte umfasst:
- Erfassen (101) der Kapazitätsveränderungen der Elektroden (E1, E2), wobei die Erfassung (101) von der Verarbeitungseinheit (UT) des kapazitiven Sensors (C) durchgeführt wird,
- Auslösen (102) einer Aktion an einer Tür (P) eines Kraftfahrzeugs durch die Verarbeitungseinheit (2), wobei die Auslösung (102) erfolgt, wenn die Signaturen (CE1, CE2) der Kapazitätsveränderungen jeder der zwei Elektroden (E1, E2) für die Annäherung einer Hand an die zwei Erfassungszonen (Z1, Z2) repräsentativ sind.

## Claims

1. Sensor (1) for triggering an action on a door (P) of a motor vehicle comprising:
- a first capacitance-measuring electrode (E1) defining a first detection zone (Z1) and a second capacitance-measuring electrode (E2) defining a second detection zone (Z2), said first electrode (E1) and said second electrode (E2) being arranged so that said first zone (Z1) and said second zone (Z2) are offset in space,
- a processing unit (UT) connected to said first electrode (E1) and to said second electrode (E2) to detect variations of capacitance of the two electrodes (E1, E2) and to generate a triggering action on the door (P) of the motor vehicle as a function of the signatures (CE1, CE2) of the capacitance variations of each of the two electrodes (E1, E2) due to the approach of a hand to the two detection zones (Z1, Z2),
**characterized in that** each electrode (E1, E2) is connected to the processing unit (UT) by means of a single connection (C) connected to the processing unit (UT), said single connection (C) alternately forming a measurement input (E) suitable for measuring the capacitance variation of the electrode or a command output (S) suitable for controlling the potential of the corresponding electrode, the single connections of the processing unit (UT) associated with the two electrodes (E1, E2) being also suitable for:
- setting the potential of the first electrode (E1) at the same level as that of the second electrode (E2), or
- setting the potential of the second electrode (E2) at the same level as that of the first electrode (E1),
a setting of the potential being ensured periodically and alternately between the first electrode (E1) and the second electrode (E2).

2. Triggering sensor (1) according to the preceding claim, wherein the second electrode (E2) is a bi-electrode, such that the surface of the second zone (Z2) is increased.

3. Triggering sensor (1) according to one of the preceding claims, comprising a so-called guard plane (PG) .

4. Triggering sensor (1) according to one of the preceding claims, wherein the second electrode (E2) is suitable for being positioned facing a conductive element (2).

5. Gripping lever (L), **characterized in that** it comprises a triggering sensor (1) according to one of the preceding claims.

6. Method for triggering (100) an action on a door of a motor vehicle implementing the triggering sensor (1) according to one of the preceding claims, said method (100) comprising the steps of:
- detecting (101) variations of capacitance of the electrodes (E1, E2), said detection (101) being performed by the processing unit (UT) of the capacitive sensor (C),
- triggering (102) an action on a door (P) of a motor vehicle by the processing unit (2), said triggering (102) being performed if the signatures (CE1, CE2) of the capacitance variations of each of the two electrodes (E1, E2) are representative of the approach of a hand to the two detection zones (Z1, Z2) .
